# EUROPEAN PATENT APPLICATION

(11) **EP 3 859 797 A1**
(43) Date of publication of application: **04.08.2021**
(21) Application number: 20382066.7
(22) Date of filing: 31.01.2020
(51) Int. Cl.: H01L 31/18

(54) **METHOD AND APPARATUS FOR ARRANGING RIBBONS AND SOLAR CELLS**

(71) Applicant: Mondragon Assembly, S.Coop, 20550 Aretxabaleta (ES)
(72) Inventor: AGUERRE, Jean-Philippe, 64250 ITXASSOU (FR); GARCIA ECHEVARRIA, Gorka, 48230 ELORRIO (ES); HERNANDEZ MATEO, Xabier, 20012 DONOSTIA (ES); ARAGONES REBOLLO, Jose Maria, 20550 ARETXABALETA (ES); ALIAGA GARCIA, OIER, 20500 ARRASATE - MONDRAGON (ES)
(74) Representative: Igartua, Ismael

(57) **Abstract**

The invention relates to a method and an apparatus for arranging ribbons and solar cells. A ribbon (1) with a first longitudinal end (1.1) and an opposite second longitudinal end (1.2) is arranged in a required position, and the second longitudinal end (1.2) is guided transversely by means of a guiding device (2) cooperating with said second longitudinal end (1.2). A cell (3) is arranged in a first position (3P1) in which a first part (3.1) of the cell (3) is arranged on the ribbon (1) and a second part (3.2) of said cell (3) is arranged on the guiding device (2); and the second longitudinal end (1.2) of the ribbon (1) is released from said guiding device (2), such that the second part (3.2) of the cell (3) falls onto said second longitudinal end (1.2) of said ribbon (1).

## Description

### TECHNICAL FIELD

The present invention relates to methods and apparatus for arranging ribbons and solar cells in installations for manufacturing solar panels.

### PRIOR ART

Installations for generating solar panels have several stations. Generally, panels are formed by means of attaching strings of solar cells, and after attaching a plurality of strings to one another and in parallel, the assembly formed as a result of the attachment is mounted, giving rise to a solar panel.

Each string of cells comprises a given number of cells connected in series, and the connection is performed by means of several cables (also known as ribbons or strips), which are electrically conductive and extend in parallel (connecting the positive part of one cell with the negative part of the next cell, interlacing all of the cells, and ending in one positive pole and another negative pole, which constitute the outer connections of the resulting photovoltaic module). As a general rule, the cables are wound independently.

A conventional method for generating a string of cells is described a continuation. Firstly, a cell is arranged on a platform, which is generally a conveyor belt. A tool grips one end of each cable and, by stretching it, positions a section of each unwound cable on the cell, such that a first part of the cables is on the cell and a second part on the platform. A new cell is then arranged on said second part of the cables. Suction is applied from the lower part of the conveyor belt to keep the cells and cables in place.

Each cell has given welding areas configured so that the cable is attached to them in said areas. With this type of method, the problem is that it cannot be assured that the second part of the cables is arranged exactly below the welding area of the corresponding cell. This error in alignment between cable and cell does, however, allow generally achieving a sufficient electrical connection, and therefore, this method of alignment prior to welding is generally accepted. This is because one face of the solar panel, that is, the face corresponding to the second part of the cables, is located on the back part, which in the case of "monofacial" type panels is usually opaque, and therefore hidden from view (not seen).

However, there is a new requirement for solar panels to be exposed on both faces, because it improves efficiency. For these cases, while the electrical connection generated with the second part of the cables is still acceptable, the aesthetics are not. This makes it necessary to search for new methods for generating strings of cells for the purpose of eliminating the described drawback.

In addition to the aesthetic drawback, the increase in efficiency of photovoltaic panels requires an increasingly larger number of cables for extracting the generated current, while at the same time the section of each of these cables is reduced. Reducing the section of these cables implies a decrease in the width thereof, and the error in alignment between photovoltaic cell and cable is staring to become a limiting factor given that the electrical connection can be seriously jeopardized in the event that the error in alignment is greater than the width of the cable. In the case of a substantial error in alignment, it leads to the situation where the interconnection by either welding or conductive adhesives does not allow the transference of electricity because the areas provided in the cell for the interconnection are completely separated from the cables.

EP1974396A1 describes an apparatus and a method solving this problem. To that end, the solution that is contemplated modifies the described concept of the installation. In this case, the already cut cables are arranged on the conveyor belt, and they are arranged in the required position with the required means. It is thereby assured that the second part of the cables is in the required position, solving the problem described above. However, this change in concept makes it necessary to completely redesign installations, and it furthermore requires more space, in addition to being more complex as more elements are required.

US2017/0229602A1 also discloses an apparatus and a method solving the problem initially described, and in this case it is done without having to modify the concept of the installation (unlike what is proposed in EP1974396A1). In this case, the second part of the cables is arranged on the platform or conveyor belt as said cables are being unwound, maintaining the general concept of installations of this type. The biggest problem in installations of this type for arranging or keeping the second part of the cables in place is the zero accessibility to such cables from the lower area, due to the suction that is generally applied to keep the cells in place. To avoid this problem and solve the problem described above, this document discloses a solution in which the second cell is arranged in cantilever fashion, i.e., with one end not supported on the platform or conveyor belt, such that it, and therefore the second part of the cables, can be accessed from below. With this solution, the ribbons can thereby be conveniently held from below, without having to dispense with the section to do so. To that end, this solution comprises incorporating an additional tool that acts from below and has special characteristics to enable gripping said second part of the cables and position or keep them in the required position.

### DISCLOSURE OF THE INVENTION

The object of the invention is to provide a method and an apparatus for arranging ribbons and solar cells in an installation for manufacturing solar panels, as defined in the claims.

A first aspect relates to a method for arranging ribbons and solar cells in an installation for manufacturing solar panels. In the method, at least one ribbon of a given length with a first longitudinal end and an opposite second longitudinal end, which is electrically conductive and is also known as a strip or cable, for example, is arranged in a required position, such that said ribbon is extended longitudinally.

With the ribbon arranged in the required position, the second longitudinal end of said ribbon is guided transversely by means of a guiding device comprising a guiding segment cooperating with said second longitudinal end to perform said transverse guiding, and a cell is arranged in a first attachment position in which a first part of said cell is arranged on the ribbon and a second part of said cell is arranged on the guiding segment of the guiding device, such that in said first attachment position the cell is deformed. The guiding device is then removed to release the ribbon (the second longitudinal end of said ribbon) from said guiding device, such that the second part of the cell falls onto the second longitudinal end of said ribbon.

Therefore, in the interval that lapses between the arrangement of the ribbon in the required position (and being guided by the guiding device) and the arrangement of the cell on said ribbon, the second longitudinal end of said ribbon is kept transversely immobilized as a result of the guiding device (the transverse guiding is, therefore, a transverse immobilization) and is correctly positioned with respect to the cell when said cell falls onto same. This is achieved without the need to arrange part of the cell in cantilever fashion, for example, as a result of the fact that, with the guiding device, a deformation of the cell is provided which prevents requiring said second longitudinal end to be held from its lower part.

A second aspect relates to an apparatus for arranging ribbons and solar cells in an installation for manufacturing solar panels. The apparatus comprises a first conveyor device configured for arranging in a required position at least one ribbon of a given length and with a first longitudinal end and an opposite second longitudinal end, such that said ribbon is extended longitudinally.

The apparatus further comprises a guiding device comprising a guiding segment which, with the guiding device in an immobilization position, is configured for cooperating with the second longitudinal end of the ribbon arranged in the required position and, with said cooperation, for transversely guiding said second longitudinal end; a second conveyor device configured for arranging a cell in a first attachment position with the ribbon in the required position and with the guiding device in the immobilization position, such that in said first position a first part of said cell is arranged on the ribbon, and in contact with said ribbon, and a second part of said cell is arranged on the guiding device, without being in contact with the ribbon, the cell being deformed in said first attachment position; a third conveyor device configured for moving the guiding device between the immobilization position and a removal position in which said guiding device does not cooperate with said second longitudinal end; and a control device configured for controlling the actuation of the transport devices. The advantages described for the method are also obtained for the apparatus.

These and other advantages and features of the invention will become apparent in view of the figures and the detailed description of the invention.

### DESCRIPTION OF THE DRAWINGS

Figure 1 schematically shows different elements of an embodiment of the apparatus for arranging ribbons and solar cells according to the invention, with a guiding device of said apparatus in a guiding position.
Figure 2a is a schematic side view of a guiding device of an embodiment of the apparatus for arranging ribbons and solar cells according to the invention.
Figure 2b is a perspective view of the guiding device of Figure 2a.
Figure 2c shows a schematic plan view of section A-A of Figure 2b.
Figure 3 schematically shows the elements of the apparatus for arranging ribbons and solar cells of Figure 1, with the guiding device of said apparatus in a removal position.

### DETAILED DISCLOSURE OF THE INVENTION

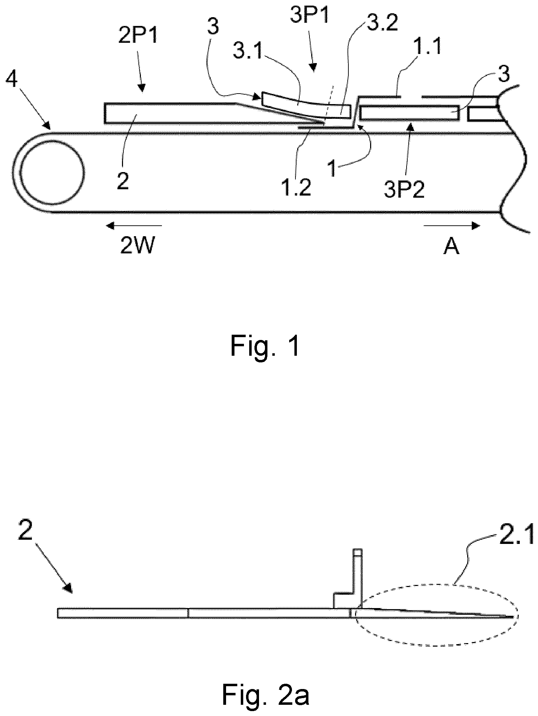

The first aspect of the invention relates to a method for arranging ribbons and solar cells in an installation for manufacturing solar panels. In the method, there is arranged in a required position at least one ribbon 1 of a given length and with a first longitudinal end 1.1 and an opposite second longitudinal end 1.2, such that said ribbon 1 is extended longitudinally in said required position. The ribbon 1 is preferably arranged extended on a support surface, said support surface preferably comprising a conveyor belt 4 as depicted in Figure 1. A plurality of ribbons 1 is preferably arranged in parallel. For the sake of clarity, Figure 1 depicts the ribbon 1 separated from the conveyor belt 4, but said ribbon 1 would actually be arranged on said conveyor belt 4 (at least the second end 1.2, as clarified below).

Preferably, for arranging the ribbon 1 in the required position a free end of a coil of wire is gripped, said end thus gripped is moved longitudinally in a forward movement direction A, unwinding it (the center of the coil is not moved longitudinally, but rather rotates as the coil of wire is pulled), until an unwound section of a given length equal to the given length of the ribbon 1 is arranged in the required position, and said section is cut, separating it from the coil of wire, such that the cut section is the ribbon 1. The previously gripped free end is the first longitudinal end 1.1 of the ribbon 1 (of the cut section).

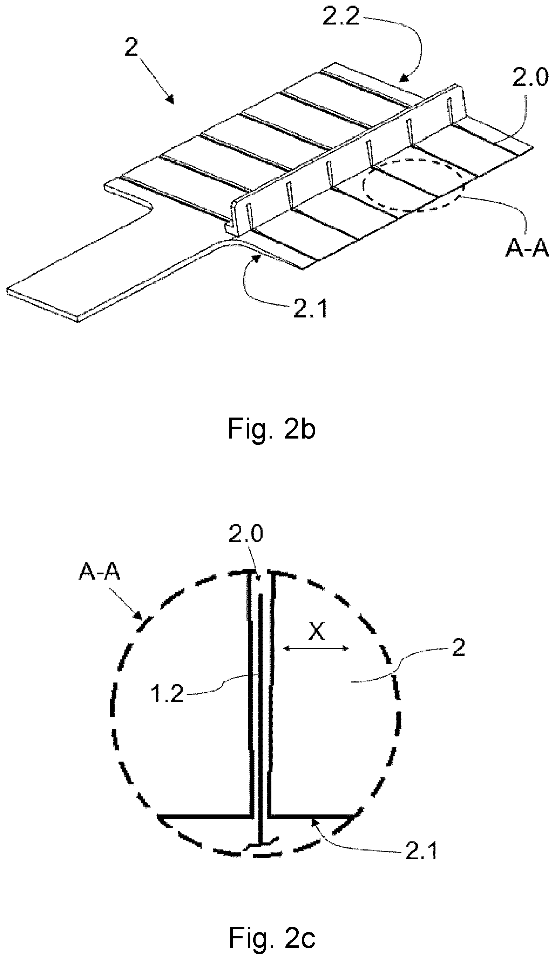

When the ribbon 1 is arranged in the required position, the second longitudinal end 1.2 of said ribbon 1 is guided transversely by means of a guiding device 2, as depicted in Figure 1. The guiding device 2, depicted by way of example in Figures 2a, 2b and 2c, comprises a guiding segment 2.1 cooperating with said second longitudinal end 1.2, such that said guiding device 2 prevents the transverse movement of said second longitudinal end 1.2. To that end, the guiding device 2 is arranged in a guiding position 2P1 (see Figure 1), being arranged at least partially on the support surface, when the ribbon 1 is arranged in the required position on said support surface. The ribbon 1 can be arranged in the required position before the guiding device 2 is arranged in the guiding position 2P1, after the guiding device 2 is arranged in the guiding position 2P1, or at the same time that the guiding device 2 is arranged in the guiding position 2P1.

The guiding device 2 preferably comprises at least one longitudinal slot 2.0 or groove in the guiding segment 2.1 for each ribbon 1 that is arranged in the required position, the second longitudinal end 1.2 of the ribbon 1 being arranged or housed in said slot 2.0 when the guiding device 2 transversely guides said second longitudinal end 1.2, said guiding device 2 thus cooperating with said second longitudinal end 1.2. Figure 2c schematically depicts said cooperation, the separation between said second longitudinal end 1.2 and the walls of the guiding device 2 between which the slot 2.0 is demarcated having been exaggerated for the sake of clarity, and it can be seen how the slot 2.0 prevents the transverse movement (in direction X) of the second longitudinal end 1.2, thus transversely guiding said second longitudinal end 1.2.

In Figure 1, for the sake of clarity, the guiding device 2 is arranged separated from both the ribbon 1 and the conveyor belt 4, but actually it would preferably be at the same level as the conveyor belt 4, and part of the ribbon 1 would be housed in a slot 2.0 of said guiding device 2 (the part of the ribbon 1 depicted in Figure 1 below the guiding device 2).

With the ribbon 1 arranged in the required position and the guiding device 2 arranged in the guiding position, in the method a solar cell 3 is arranged in a first attachment position 3P1. In this first attachment position 3P1, a first part 3.1 of said cell 3 is arranged on the ribbon 1 (in contact with the ribbon 1) and a second part 3.2 of said cell 3 is arranged on the guiding segment 2.1 of the guiding device 2 (without being in contact with the ribbon 1), the first part 3.1 and the second part 3.2 being distributed longitudinally with respect to ribbon 1. Therefore, while in the first attachment position 3P1 the cell 3 is in contact with the ribbon 1 (the first part 3.1), and in cases in which the ribbon 1 is on the support surface, said cell 3 presses said ribbon 1 against said support surface. When both the ribbon 1 and the guiding device 2 are arranged on a support surface, the ribbon 1 is arranged on the plane of said support surface whereas the guiding segment 2.1 projects above said plane, for which reason the cell 3 is deformed when it is in the first attachment position 3P1. Figure 1 shows the ribbon in the required position on a conveyor belt 4, a deformed cell 3 in the first attachment position 3P1, and the guiding device 2 cooperating with the ribbon 1, but said ribbon 1 is shown separated from the cell 3 and from the conveyor belt 4 for the sake of clarity. In Figure 1, for the sake of clarity, the cells 3 have also been depicted separated from the remaining elements.

Since the ribbon 1 is extended and its second longitudinal end 1.2 is housed or arranged in the guiding segment 2.1 of the guiding device 2 such that the transverse movement of said second longitudinal end 1.2 is prevented, as described above, the guiding segment 2.1 projects at least partially above the ribbon 1 (conversely, the second longitudinal end 1.2 would not be housed in the guiding device 2). Since the second part 3.2 of said cell 3 is arranged on said guiding segment 2.1, said second part 3.2 is not in contact with the ribbon 1 and said cell 3 is deformed when it is in the first attachment position 3P1.

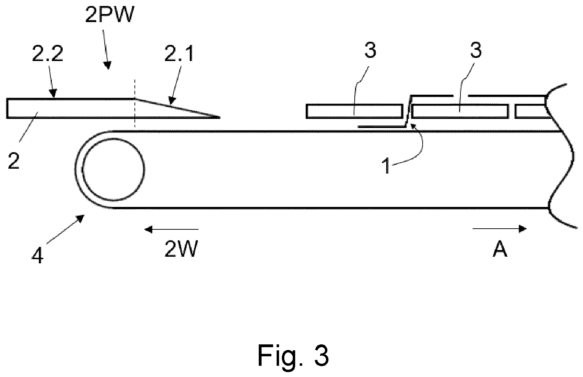

In the method, the guiding device 2 is then removed to release the second longitudinal end 1.2 of the ribbon 1 from said guiding device 2, and since the second part 3.2 of the cell 3 was supported on the guiding segment 2.1 of said guiding device 2, when said guiding device 2 is removed, said second part 3.2 of the cell 3 falls onto the second longitudinal end 1.2 of said ribbon 1 (see Figure 3, where the ribbon 1 is depicted separated from the cells 3 for the sake of clarity, as occurs in Figure 1). Since said second longitudinal end 1.2 was in the required position (without transverse movements), as a result of the guiding device 2 (the guiding segment 2.1 of said guiding device 2), said second longitudinal end 1.2 is correctly positioned with respect to the cell 3 when the latter falls onto same. Preferably, the ribbon 1 is on the support surface, such that the cell 3 presses said second longitudinal end 1.2 of the ribbon 1 against said support surface.

Preferably, to remove the guiding device 2 a longitudinal movement of said guiding device 2 in a removal direction 2W, moving away from of the first longitudinal end 1.1 of said ribbon 1, is caused. The guiding device 2 is thereby moved linearly, making the handling and correct positioning thereof in the guiding position 2P1 easier.

In the case of the ribbon 1 being arranged on a support surface, suction is preferably applied on what is arranged on said support surface, particularly on the ribbon 1 and the cell 3, from the lower part of said support surface, and preferably through a plurality of holes (not depicted in the drawings) of said support surface. Both the ribbon 1 and the cell 3 are thereby kept in place. Applying suction of this type is already known in the sector, but without the guiding device 2, which allows keeping the second longitudinal end 1.2 of the ribbon 1 in the required position; when the ribbon 1 is arranged in the required position it would not be assured that it is correctly positioned at first, and the suction would keep it in the position in which it had been placed (whether correct or not). The use of a guiding device 2 of this type is particularly advantageous in those methods in which the ribbon 1 is wound like a coil and moved in the forward movement direction A for arranging it in the required position (a section of said coiled ribbon) and has been previously described.

In the method, after removing the guiding device 2 the cell 3 and ribbon 1 are moved together in a longitudinal forward movement direction A opposite the removal direction 2W, said cell 3 being arranged in a second attachment position 3P2. The method thus comprises a manufacturing cycle with the following steps (in the indicated order):
- arranging a ribbon 1 in the required position and arranging the guiding device 2 in the guiding position 2P1;
- arranging a cell 3 in the first attachment position 3P1;
- removing the guiding device 2; and
- moving the cell 3 and the ribbon 1 together in a longitudinal forward movement direction A opposite the removal direction 2W, said cell 3 being arranged in a second attachment position 3P2.

Once one manufacturing cycle has ended, a new manufacturing cycle can begin, and in the new manufacturing cycle, the first longitudinal end 1.1 of the ribbon 1 is arranged on the cell 3 which is arranged in the second attachment position 3P2 after the immediately prior manufacturing cycle.

After arranging the ribbon 1 and the cell 3 in the second attachment position 3P2, said ribbon 1 and the cell 3 are interconnected by means of an interconnection device not depicted in the drawings. Before arranging the cell 3 in the first attachment position 3P1, both faces of said cell 3 are preferably impregnated with an adhesive (which at the same time is an electrically conductive material), at least in the areas in which the ribbon 1 is to be arranged. As a result of the adhesive, when the cell 3 and the first longitudinal end 1.1 of a ribbon 1 come into contact said first longitudinal end 1.1 is adhered to the cell 3 and in the correct position from the start (for which reason no further action is required for positioning it correctly, as occurs with the second longitudinal end 1.2), and when said cell 3 and the second longitudinal end 1.2 of a ribbon 1 come into contact said second longitudinal end 1.2 is adhered to said cell 3 (which is adhered in the correct position as a result of the guiding device 2). The first longitudinal end 1.1 comes into contact with one of the faces of the cell 3, and the second longitudinal end 1.2 comes into contact with the other face of said cell 3. The interconnection device secures this adhesion by hardening it (by means of heat, for example), the ribbon 1 and the cell 3 thus being interconnected. This interconnection can be carried out, for example, once the ribbon 1 has been arranged in the required position during a manufacturing cycle.

Alternatively, the ribbon 1 and the cell 3 can be conveyed from the second attachment position 3P2 to a third attachment position not depicted in the drawings, where it is in said position that the interconnection is carried out. In this case, the interconnection is carried out once a new cell 3 has been conveyed to said third attachment position.

A second aspect of the invention relates to an apparatus for arranging ribbons and solar cells. The apparatus comprises a first conveyor device not depicted in the drawings, which is configured for arranging in a required position at least one ribbon 1 of a given length with a first longitudinal end 1.1 and an opposite second longitudinal end 1.2, such that said ribbon 1 is extended longitudinally. The first conveyor device can comprise a robotic arm, for example, or another conventional conveyor device.

The ribbon 1 is preferably generated from a coil of wire (a wire wound like a coil), and for arranging it in the required position, the first conveyor device is configured for gripping a free end of the coil of wire and for moving it longitudinally in the forward movement direction A, until arranging a section of a given length equal to the given length of the ribbon 1 in the required position, said section being the ribbon 1. In this case, the apparatus further comprises a cutting tool, not depicted in the drawings, for cutting said section and separating it from the rest of the coil of wire, such that the cut section is the ribbon 1 and it comprises the two longitudinal ends 1.1 and 1.2 described. The first longitudinal end 1.1 is the free end of the coil of ribbon previously gripped by the first conveyor device. The cutting tool can be integrated in said first conveyor device.

The apparatus further comprises a guiding device 2 with a guiding segment 2.1, as described for the first aspect of the invention. The guiding segment 2.1 is configured for housing the second longitudinal end 1.2 of the ribbon 1 with the guiding device 2 in a guiding position 2P1 and the ribbon 1 (the section corresponding described in the preceding paragraph, where appropriate) arranged in the required position, and to that end it preferably comprises one longitudinal slot 2.0 or groove for each ribbon 1 that is arranged in the required position. The second longitudinal end 1.2 of the ribbon 1 is arranged or housed in said slot 2.0 when the guiding device 2 transversely guides said second longitudinal end 1.2, said guiding device 2 thus housing said second longitudinal end 1.2, and the guiding device 2 thus cooperating with said second longitudinal end 1.2. With this cooperation, said guiding device 2 transversely guides said second longitudinal end 1.2, preventing the transverse movement of said second longitudinal end 1.2 (the walls or surfaces demarcating the slot 2.0 are those which prevent said transverse movement).

The apparatus also comprises a second conveyor device not depicted in the drawings and configured for arranging a cell 3 in a first attachment position 3P1, with the ribbon 1 in the required position and with the guiding device 2 in the guiding position 2P1, such that with the cell 3 in said first position 3P1, a first part 3.1 of said cell 3 is arranged on the ribbon 1 (in contact with said ribbon 1) and a second part 3.2 of said cell 3 is arranged on the guiding device 2 (without being in contact with the ribbon 1). The second conveyor device can comprise a robotic arm, for example, or another conventional conveyor device.

The apparatus also comprises a third conveyor device (not depicted in the drawings) configured for moving the guiding device 2 longitudinally from the guiding position 2P1 to a removal position 2PW in a removal direction 2W (and in the opposite direction for moving it from the removal position 2W to the guiding position 2P1). As shown in Figure 3 by way of example, the removal position 2PW is a position other than the guiding position 2P1, and in said removal position 2PW, the guiding device 2 does not cooperate with the second longitudinal end 1.2. The third conveyor device can comprise a robotic arm, for example, or another conventional conveyor device. In Figure 3, for the sake of clarity and as occurs in Figure 1, the guiding device 2 and the cells 3 are arranged separated from the conveyor belt 4, but actually they would preferably be arranged at the same level as the conveyor belt 4 (like the part of the ribbon 1 that is not on any cell 3).

The apparatus further comprises a control device not depicted in the drawings, which is configured for controlling the actuation of all the transport devices (and when said actuations are generated), and it may comprise, for example, a controller, a microprocessor, an FPGA, or any device with computing capacity. The control device is thus configured for causing the second conveyor device to arrange a cell 3 in a first attachment position 3P1, with the ribbon 1 in the required position and with the guiding device 2 in the guiding position 2P1, and for causing the third conveyor device to move the guiding device 2 from the guiding position 2P1 to the removal position PW once the first conveyor device has arranged a cell 3 on said guiding device 2.

The apparatus comprises a fourth conveyor device configured for moving a ribbon 1 and a cell 3 arranged on the ribbon 1 together, in a longitudinal forward movement direction A opposite the removal direction 2W, until arranging said cell 3 in a second attachment position 3P2 as described above for the first aspect of the invention. The control device is also configured for controlling the actuation of said fourth conveyor device, said control device being configured for causing the movement of a ribbon 1 and a cell 3 arranged on the ribbon 1 together in the forward movement direction A, once the guiding device 2 has been removed from the guiding position 2P1 and the cell 3 has fallen onto the ribbon 1.

The fourth conveyor device preferably comprises a conveyor belt 4, and for arranging the ribbon 1 in the required position, the first conveyor device is configured for arranging said ribbon 1 on said conveyor belt 4. The apparatus preferably comprises suction means arranged below the conveyor belt 4, and the conveyor belt 4 comprises a plurality of holes (not depicted in the drawings) through which the suction means cause a suction on what is arranged on top of said conveyor belt 4, the ribbon 1 and the cell 3 arranged on said conveyor belt 4 being kept in place with said suction, as described for the first aspect of the invention.

The guiding device 2 comprises a main segment 2.2 in addition to the guiding segment 2.1. The main segment 2.2 is in a first plane which is on a higher level than a second plane, which is the plane where arranged the ribbon 1 is arranged in the required position, and the guiding segment 2.0 acts as a transition between the first plane and the second plane. To that end, the guiding segment 2.1 can define different configurations, such as a linear configuration defining a given angle with respect to the first plane or a curved configuration. The second conveyor device is configured for arranging the second part 3.2 of a cell 3 on said guiding segment 2.1, when it arranges said cell 3 in the first position 3P1.

Generally, that which is described for the method of the invention, in any of its embodiments and/or configurations, is also valid for the embodiments and/or configurations of the apparatus of the invention. Said apparatus thus comprises the embodiment and/or configuration suitable for supporting the corresponding embodiment and/or configuration of said method.

Likewise, that which is described for the apparatus of the invention, in any of its embodiments and/or configurations, is also valid for the embodiments and/or configurations of the method of the invention. Said method thus comprises the embodiment and/or configuration suitable for the corresponding embodiment and/or configuration of said apparatus.

Another aspect of the invention relates to an installation for manufacturing solar panels comprising an apparatus for arranging ribbons and solar cells according to the second aspect of the invention (in any of its embodiments and/or configurations), and/or to an installation for manufacturing solar panels configured for supporting a method according to the first aspect of the invention (in any of its embodiments and/or configurations).

## Claims

1. Method for arranging ribbons and solar cells in an installation for manufacturing solar panels, wherein at least one ribbon (1) of a given length and with a first longitudinal end (1.1) and an opposite second longitudinal end (1.2) is arranged in a required position, such that said ribbon (1) is extended longitudinally, **characterized in that** with the ribbon (1) arranged in the required position, the second longitudinal end (1.2) of said ribbon (1) is guided transversely by means of a guiding device (2) comprising a guiding segment (2.1) cooperating with said second longitudinal end (1.2) for said transverse guiding; a cell (3) is arranged in a first attachment position (3P1) in which a first part (3.1) of the cell (3) is arranged on the ribbon (1), and in contact with said ribbon (1), and a second part (3.2) of said cell (3) is arranged on the guiding segment (2.1) of the guiding device (2); and the guiding device (2) is removed to release the second longitudinal end (1.2) of the ribbon (1) from said guiding device (2), such that the second part (3.2) of the cell (3) falls onto said second longitudinal end (1.2) of said ribbon (1).

2. Method according to claim 1, wherein to remove the guiding device (2) a linear longitudinal movement of said guiding device (2) in a removal direction (2W) is caused, moving away from the first longitudinal end (1.1) of the ribbon (1).

3. Method according to claim 2, wherein after removing the guiding device (2), the cell (3) and the ribbon (1) are moved together in a linear longitudinal forward movement direction (A) opposite the removal direction (2W), said cell (3) being arranged in a second attachment position (3P2).

4. Method according to any of claims 1 to 3, wherein the guiding device (2) is arranged in a guiding position (2P1) for transversely guiding the second longitudinal end (1.2) of the ribbon (1), said guiding device (2) being arranged in said guiding position (2P1) before, after, or at the same time that said ribbon (1) is arranged in the required position.

5. Method according to any of claims 1 to 4, wherein the guiding device (2) comprises at least one longitudinal slot (2.0) or groove, the second longitudinal end (1.2) of the ribbon (1) being housed or arranged in said slot (2.0) when the guiding device (2) transversely guides said second longitudinal end (1.2).

6. Method according to any of claims 1 to 5, wherein the ribbon (1) is arranged on a conveyor belt (4) when it is arranged in the required position, and the guiding device (2) is arranged at least partially on said conveyor belt (4) for transversely guiding the second longitudinal end (1.2) of said ribbon (1).

7. Method according to any of claims 1 to 6, wherein for arranging the ribbon (1) in the required position, a free end of a coil of ribbon is gripped, said free end is moved longitudinally in a forward movement direction (A), unwinding it, until arranging a section of a given length equal to the given length of the ribbon (1) in the required position, and said section is cut such that the cut section is the ribbon (1) and comprises the two longitudinal ends (1.1, 1.2), the gripped free end of the coil of ribbon being the first longitudinal end (1.1) of the ribbon (1).

8. Apparatus for arranging ribbons and solar cells comprising a first conveyor device configured for arranging in a required position at least one ribbon (1) of a given length and with a first longitudinal end (1.1) and an opposite second longitudinal end (1.2), such that said ribbon (1) is extended, **characterized in that** it further comprises a guiding device (2) comprising a guiding segment (2.1) configured for cooperating with the second longitudinal end (1.2) of the ribbon (1) with the guiding device (2) in a guiding position (2P1), such that with said cooperation it transversely guides said second longitudinal end (1.2); a second conveyor device configured for arranging a cell (3) in a first attachment position (3P1) with the ribbon (1) in the required position and with the guiding device (2) in the guiding position (2P1), such that in said first attachment position (3P1) a first part (3.1) of said cell (3) is arranged on the ribbon (1), and in contact with said ribbon (1), and a second part (3.2) of said cell (3) is arranged on the guiding segment (2.1) of the guiding device (2); a third conveyor device configured for moving the guiding device (2) between the guiding position (2P1) and a removal position (2PW) in which said guiding device (2) does not cooperate with said second longitudinal end (1.2); and a control device configured for controlling the actuation of the transport devices.

9. Apparatus according to claim 8, wherein the control device is configured for causing the third conveyor device to move the guiding device (2) from the guiding position (2P1) to the removal position (2PW) by means of the longitudinal movement of said guiding device (2) in a removal direction (2W), once the first conveyor device has arranged a cell (3) on said guiding device (2).

10. Apparatus according to claim 9, comprising a fourth conveyor device configured for moving a ribbon (1) and a cell (3) arranged on the ribbon (1) together in a longitudinal forward movement direction (A) opposite the removal direction (2W), until arranging said cell (3) in a second attachment position (3P2).

11. Apparatus according to claim 10, wherein the fourth conveyor device comprises a conveyor belt (4), the first conveyor device being configured for arranging the ribbon (1) on said conveyor belt (4) in the required position.

12. Apparatus according to claim 10 or 11, wherein the control device is configured for controlling the actuation of the fourth conveyor device, said control device being configured for causing the movement of a ribbon (1) and a cell (3) arranged on the ribbon (1) together in the forward movement direction (A) once the guiding device (2) has been removed from the guiding position (2P1) and the cell (3) falls onto the ribbon (1).

13. Apparatus according to any of claims 8 to 12, wherein the guiding device (2) comprises at least one longitudinal slot (2.0) or groove configured for housing the second longitudinal end (1.2) of a ribbon (1), thus guiding said second longitudinal end (1.2) transversely, said slot (2.0) being in the guiding segment (2.1) of said guiding device (2.0).

14. Apparatus according to any of claims 8 to 13, wherein the guiding segment (2.1) of the guiding device (2.0) comprises a linear or curved configuration.

15. Apparatus according to any of claims 8 to 14, wherein the first conveyor device is configured for gripping a free end of a coil of ribbon and for moving it thus gripped in a forward movement direction (A), unwinding it, until arranging a section of a given length in the required position, the apparatus comprising a cutting tool for cutting said section and separating it from the coil of ribbon, such that said cut section is the ribbon (1) comprising the two longitudinal ends (1.1, 1.2), the first longitudinal end (1.1) of said ribbon (1) being the free end of the coil of ribbon previously gripped by the first conveyor device.
